(19) **Europäisches Patentamt / European Patent Office / Office européen des brevets**

(11) **EP 4 685 106 A1**

(12) **EUROPEAN PATENT APPLICATION**

(43) Date of publication:
28.01.2026 Bulletin 2026/05

(21) Application number: 24382803.5

(22) Date of filing: 23.07.2024

(51) International Patent Classification (IPC):
**B82Y 10/00** (2011.01)  **B82Y 25/00** (2011.01)
**G06N 3/065** (2023.01)  **H03B 15/00** (2006.01)
**H10N 52/00** (2023.01)

(52) Cooperative Patent Classification (CPC):
**B82Y 10/00; B82Y 25/00; G01R 33/098;
G01R 33/1284; G06N 3/065; H03B 15/006**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Consejo Superior De Investigaciones Científicas
(CSIC)
28006 Madrid (ES)**

• **Universidad de Sevilla
41013 Sevilla (ES)**

(72) Inventors:
• **Fiorelli Martegani, Rafaella Bianca
41092 Sevilla (ES)**
• **Peralías Macías, Eduardo
41092 Sevilla (ES)**

(74) Representative: **Pons IP
Glorieta Rubén Darío 4
28010 Madrid (ES)**

(54) **METHOD AND DEVICE FOR MONITORING THE OUTPUT SIGNAL OF NANO-OSCILLATORS**

(57) The present invention relates to a method for monitoring the output signal of spin-Hall type nano-oscillators (SHNO) or spin-torque nano-oscillators (STNO) which employs, in turn, another SHNO (or STNO) implanted in the same substrate, which comprises the steps of combining the outputs of the NO, then amplifying the combined signal and finally applying a low/band pass filter to obtain the low frequency component of the signal. This methodology allows the lack of external detectors, improving performance and optimizing the necessary size.

**Description**

The object of the invention relates to a method for monitoring the output signal of nano-oscillators (SHNO), reducing the electronic circuitry, which decrease the size of the whole circuit and the power consumption, and increasing its performance.

**BACKGROUND OF THE INVENTION**

Recently discovered spintronic oscillators overcome the typical sensitivity of nanoscale devices to external conditions by acting magnetically. These devices can be used as microwave sources or neurons in neural network applications. Spintronic oscillators are particularly suitable for neuromorphic computing systems due to the oscillatory behaviour of the machine and their ability to synchronize electronically or electronically with other similar devices. By simulating a neuron using a single spintronic oscillator, it is possible to eliminate many transistors required to accurately reproduce neuron behaviour, thereby reducing power and space of CMOS neurons

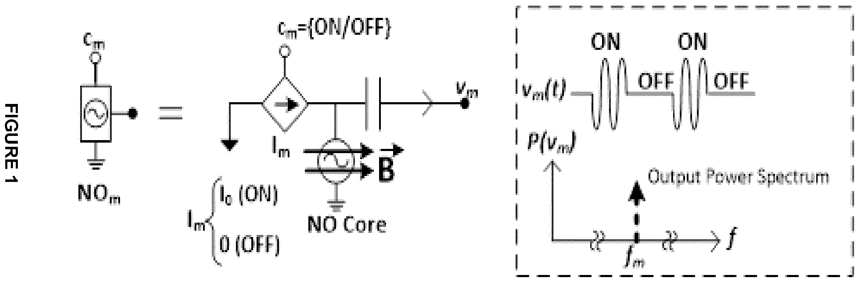

The potential of spin-torque and spin Hall effect-driven nano-oscillators (NO) is huge in applications ranging from microwave signal sources and detectors to neuromorphic computation elements, as has become apparent in recent years. These and their biasing are sketched in Figure 1. A spin-torque nano-oscillator (*STNO*) device configuration is a thick magnetic layer, which serves as a polariser, a non-magnetic spacer, and a relatively thin magnetic layer. A DC current leads to steady-state magnetisation dynamics and generates an oscillating microwave voltage. The magnetoresistive effect converts the magnetisation oscillation into a microwave voltage. A spin Hall nano-oscillator (SHNO) device consists of a ferromagnetic (FM) and non-ferromagnetic (NFM) bilayer structure, where the generation of spin current results in a spin torque present in the FM layer, which can ensure a constant precession of the magnetisation. This is achieved by applying a DC current to the NFM layer, which is converted into pure spin current flowing in the transverse direction by the spin Hall effect.

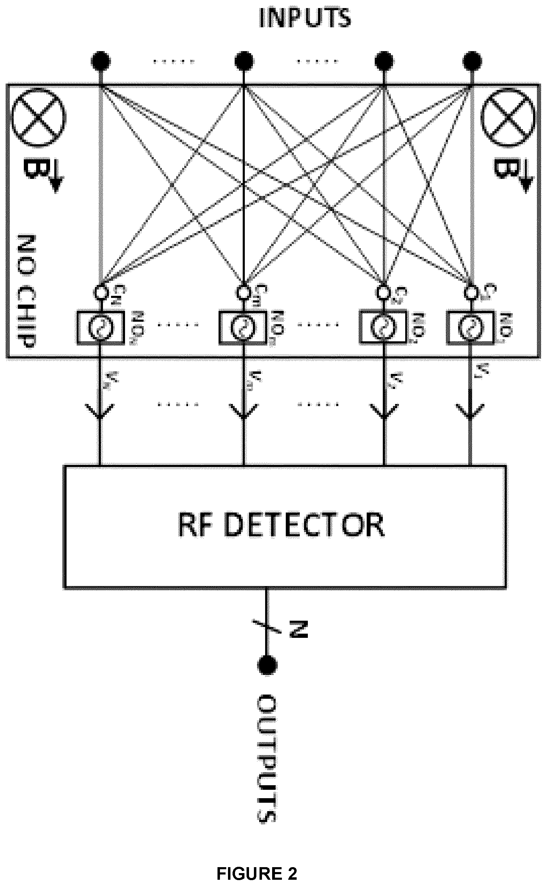

Taking this into account, one of the problem the state-of-the-art technology regarding nano-oscillators is the method for determining its output signal. Most of the current techniques carry on that process on identifying when the NO oscillates by using a radio-frequency detector external to the NO array chip and its bias circuits, as depicted in Figure 2, where that device is denoted as RF DETECTOR. It is important to develop some monitoring method that simplify the design of such detectors as well as to reduce its size and power consumption.

**DESCRIPTION OF THE INVENTION**

The object of the present invention describes a method for monitoring the output signal of one or more nano-oscillators (*NO*).

The method of the invention, comprises the steps of:

- providing at least one auxiliary nano-oscillator ($NO_{REF}$);
- providing a magnetic field ($\vec{B}$) to drive the auxiliary nano-oscillator ($NO_{REF}$) and the one or more nano-oscillators $\{NO_m\}$ to be monitored. When a bias current ($I_m = I_0 \neq 0$) is applied to one of them ($NO_m$), it oscillates at frequencies ($f_m$), in the radio-frequency/microwave (RF/MW) range. When the bias current ($I_m$) is supressed, the nano-oscillator $NO_m$ remains at rest;
- biasing the auxiliary nano-oscillator ($NO_{REF}$) to a bias current ($I_{REF}$) relatively close to ($I_0$), leading to an oscillation at a specific frequency ($f_{REF}$);
- combining the output signal of the nano-oscillator ($NO_m$) to be monitored and the auxiliary nano-oscillator ($NO_{REF}$), by using a combiner (such as a passive current adder) leads to a two-tone combined signal ($V_{mR}$) which comprises two tones with frequencies relatively close together and separated by a gap frequency ($f_{IF}$) such that:

$$f_{IF} = |f_m - f_{REF}|$$

- applying a non-linear amplification to the combined signal ($V_{mR}$) leading to an amplified multi-tone signal ($V_u$), one of whose tones is in the low frequency ($f_{IF}$) relatively close to zero; and
 applying a band-pass filtering which filters the frequency components above and below $f_{IF}$ of the amplified signal ($V_u$) obtaining the output signal ($V_{out}$).
- Alternatively, applying a low-pass filtering could be used for filtering the frequency components below $f_{IF}$ of the amplified signal ($V_u$) for obtaining the output signal ($V_{out}$).

Preferably, the low frequency component ($f_{IF}$) fulfils the following relations when $f_m \approx F_{REF}$:

$$f_{IF} \ll f_m$$

$$f_{IF} \ll f_{REF}$$

The use of a low frequency component ($f_{IF}$) for obtaining the output signal ($V_{out}$) of the one or more nano-oscillators ($NO_m$) brings the advantage of working in base-band with respect to operating in the radio-frequency or microwave band. Thus, the method and device of the invention avoids the use of an external oscillator at RF/MW frequencies, which is expensive in terms of area and energy consumption.

In addition, by applying a non-linear amplification the method of the invention allows to obtain the output signal ($V_{out}$) of the one or more nano-oscillators ($NO_m$) even when the signal level is extremely low.

The method of the invention allows to be implemented within a production line, to perform, for example, a built-in self-test. Also, the method can be used in a laboratory for metrology and characterization of the nano-oscillators ($NO_m$).

The invention also relates to a device for monitoring the output signal ($V_m$) of one or more nano-oscillators driven by a magnetic field ($\vec{B}$). The device of the invention allows monitoring more effectively and with higher performance the output signal of the nano-oscillators.

The one or more nano-oscillators ($NO_m$) oscillate at a frequency $f_m$ when a bias current ($I_m$) applied to said nano-oscillators is equal to $I_0$, and are at rest when the bias current ($I_m$) applied is supressed.

The device for monitoring the output signal ($V_{out}$) of one or more nano-oscillators ($NO_m$) of the invention comprises:

- at least one auxiliary nano-oscillator ($NO_{REF}$) configured to be driven by the magnetic field ($\vec{B}$) and biased to a bias current ($I_{REF}$) leading to an oscillation at a specific frequency ($f_{REF}$) when driven by the magnetic field ($\vec{B}$);
- a combiner connected to the nano-oscillators *(NO)* to be monitored and the auxiliary nano-oscillator ($NO_{REF}$) and configured to add an output signal of the nano-oscillators *(NO)* to be monitored and an output signal of the auxiliary nano-oscillator ($NO_{REF}$) into a two-tone combined signal ($V_{mR}$) which comprises two tones with frequencies near each other, separated by a gap frequency ($f_{IF}$);
- a non-linear amplifier connected to the combiner and configured to apply a non-linear amplification to the combined signal ($V_{mR}$), leading to an amplified signal ($V_u$) which comprises a multi-tone, one of whose components is the low frequency $f_{IF} = |f_m - F_{REF}|$, relatively close to zero;
- a band-pass filter connected to the non-linear amplifier and configured to apply a band-pass filtering above and below the low frequency component ($f_{IF}$) of the amplified signal ($V_u$) for obtaining the output signal ($V_{out}$) of the one or more nano-oscillators ($NO_m$), Alternatively, a low-pass filter could be used. The low pass filter would be connected to the non-linear amplifier and configured to apply a low-pass filtering below the low frequency component ($f_{IF}$) of the amplified signal ($V_u$) for obtaining the output signal ($V_{out}$) of the one or more nano-oscillators ($NO_m$), located at baseband.

In preferred embodiments, the nano-oscillators *(NO)* to be monitored and/or the auxiliary nano-oscillator ($NO_{REF}$) are selected from: a spin-Hall type nano-oscillators (SHNO) and spin-torque nano-oscillators (STNO).

The invention allows reducing the components of an electronic circuitry, occupying less area and reducing the power consumption.

The invention also could be applied in the form of a chip comprising:

- multiple nano-oscillators *(NO)* arranged in a neuron-like array wherein the nano-oscillators *(NO)* are configured to act as neurons; and
- a device for measuring the output signal ($V_{out}$) of the one or more nano-oscillators as described before.

In addition, the invention could be applied as a magnetic field sensor comprising:

- multiple nano-oscillators *(NO)* and
- a device for measuring the output signal ($V_{out}$) of the one or more nano-oscillators as described before.

To complement the description that is being made and for helping to better understand the features of the invention according to a preferred practical exemplary embodiment thereof, a set of drawings is attached as an integral part of said description in which the following is depicted in an illustrative and non-limiting manner:

Figure 1 shows an example of the configuration of a standard On/Off current-controlled nano-oscillator, representing a nano-oscillator ($NO_m$) to be monitored in the invention configuration. Besides, its time-dependent voltage output $V_m$ and frequency component $f_m$ in its power spectrum, are also represented.

Figure 2 shows state-of-the-art techniques for monitoring nano-oscillators *(NO)* array output, connecting the nano-oscillators array chip to an external radio-frequency detector (RF DETECTOR).

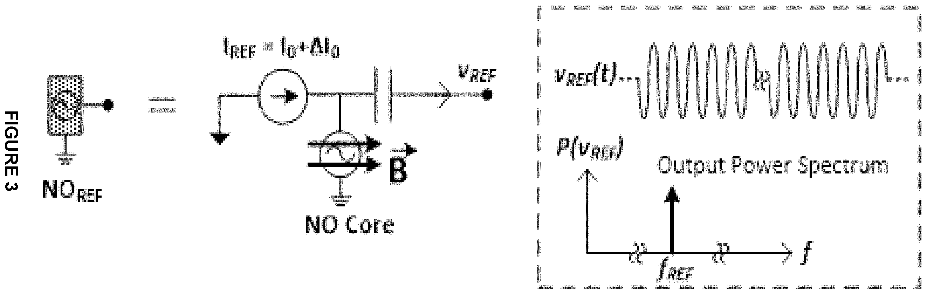

Figure 3 shows an example of the configuration of a continuous operation nano-oscillator ($NO_{REF}$) representing the auxiliary nano-oscillator to be used as a reference in the invention configuration. Besides, its time-dependent voltage output $V_{REF}$ and frequency component $F_{REF}$ in its power spectrum, are also represented.

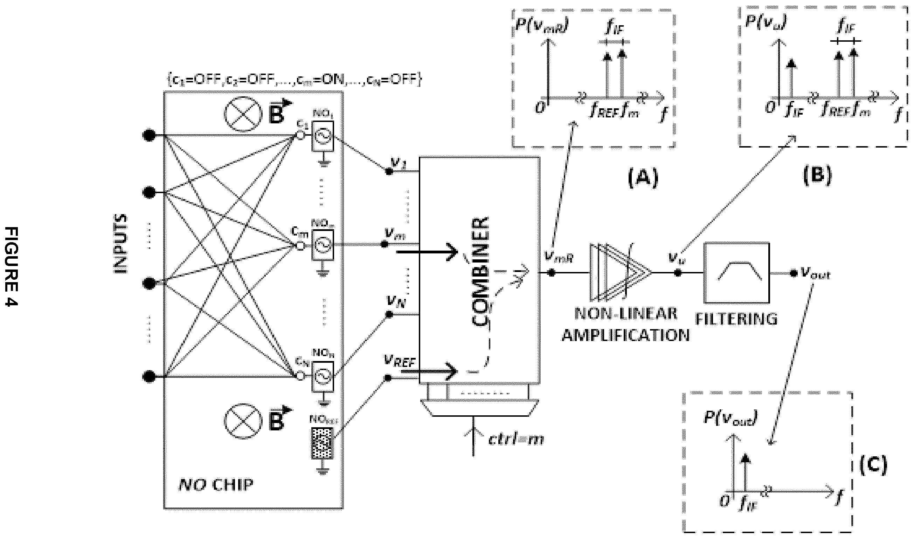

Figure 4 shows the invention configuration, wherein the auxiliary nano-oscillator ($NO_{REF}$) is connected to a combiner as well as the nano-oscillators *(NO)* to be monitored. The power spectrum of the output signal of the combiner ($V_{mR}$) is shown in subfigure (A). Next, this signal undergoes a non-linear amplification, introducing a low frequency component that can be seen in the plot of the resulting signal $V_u$ in subfigure (B). Finally, a band pass filter around $f_{iF}$ is applied to $V_u$ so that the signal $V_{out}$ is obtained,

whose spectrum is shown in subfigure (C).

## PREFERRED EMBODIMENT OF THE INVENTION

A preferred embodiment of the method for monitoring the output signal of nano-oscillators, $\{NO_m\}$, using another reference nano-oscillators ($NO_{REF}$) is described below with the help of Figures 1 to 4.

These mentioned nano-oscillators ($NO_m$, $NO_{REF}$) can be interchangeably spin-Hall type nano-oscillators (SHNO) or spin-torque nano-oscillators (STNO), being a standard nano-oscillator (NO) depicted in the Figure 1.

A reference nano-oscillator ($NO_{REF}$) is matched to the nano-oscillator ($NO_m$) to be monitored, by being excited by the same magnetic field $\vec{B}$, and its response is combined with each of the nano-oscillators $NO_m$ to be monitored, so that what is detected is the combined response by frequency translation to baseband at baseband.,

Each $NO_m$ has a voltage output $V_m$ that oscillates at a frequency $f_m$ (in the range of up to tens of gigahertz) when its on/off bias control current $I_m$ is $I_0 \neq 0$, and is at rest when $I_m$ is supressed. These features are also described in their respective representation in Figure 1.

The $NO_{REF}$ is biased to a nonstop bias current $I_{REF} \approx I_0$ such that it always oscillates at frequency $f_{REF} \approx f_m$ when the magnetic field $\vec{B}$ is applied. This is depicted in the Figure 3.

In the previous solutions to nano-oscillator (NO) monitoring, the procedure was achieved by connecting them, usually a whole nano-oscillators (NO) chip array, to an RF DETECTOR as shown in Figure 2. This device can be one of the following: a commercial spectrum analyser, commercial discrete components or, a fully integrated system.

The method of the invention, on the other hand, includes a combiner block which merges the output of each nano-oscillator to be monitored belonging to the matrix NO with the auxiliary nano-oscillator ($NO_{REF}$), and whose output is referred as $V_{mR}$. A non-linear amplification is applied to the signal $V_{mR}$ such that the resulting signal, $V_u$, contains a low frequency component $f_{IF}$, where $f_{IF} = |f_m - F_{REF}|$, and where $f_{IF} \ll f_m$ and $f_{IF} \ll f_{REF}$. Finally, applying a bandpass filtering around the frequency $f_{IF}$, the signal $V_{out}$ is obtained. This configuration is depicted in Figure 4.

The benefits of this methodology for monitoring of the oscillation state of NO devices compared to the one that are defined in the current state-of-the-art is the lack of necessity to implement complex electronic circuitry or components, such as the one of Figure 2, which enables a reduced size and a lower power consumption.

Moreover, the output signal $V_{out}$ with frequency, $f_{IF}$, used for the final detection brings the advantage of working in low frequency band with respect to operating in the radio-frequency or microwave band. This technique avoids using an external oscillator at gigahertz frequencies.

Regarding the possible applications of the present invention, the following ones are depicted in an illustrative and non-limiting manner:

1. Performing controls in a production line with the built-in self-test approach (e.g. go/no-go operation), since it is not necessary to use neither expensive external equipment (such as RF/MW spectrum analysers), nor setups with signal generators working at the $f_m$, to transfer the signal to baseband frequencies.

2. Carrying out comprehensive characterizations of NO devices in laboratory with metrology and characterization service.

3. Implementation of fully integrated systems based on neural networks made of nano-oscillators. This is an advantage over what currently exists due to the improvement their performance in three aspects:

   a) it makes feasible the fully integrated implementation of the system when the signal levels of the NOs are extremely low.
   b) it allows to reduce the size of the system to be implemented.
   c) it reduces the consumption of the system.

4. Assembling of magnetic field sensors using nano-oscillators of very small size.

## Claims

1. A method for monitoring one or more nano-oscillators $\{NO_m\}$ by detecting an output signal ($V_m$) of said nano-oscillators $\{NO_m\}$, comprising the steps of:

   - providing at least one auxiliary nano-oscillator ($NO_{REF}$);
   - providing a magnetic field ($\vec{B}$) to drive the auxiliary nano-oscillator ($NO_{REF}$) and the nano-oscillators $\{NO_m\}$ to be monitored, which oscillate at a frequency ($f_m$) when a bias current ($I_m$) applied to one or more of the nano-oscillators $\{NO_m\}$, is equal to $I_0$, and which is at rest when the bias current ($I_m$) applied is supressed;
   - biasing the auxiliary nano-oscillator ($NO_{REF}$) to a nonstop bias current ($I_{REF}$) leading to an oscillation at a specific frequency ($f_{REF}$) when driven by the magnetic field ($\vec{B}$);
   - combining an output signal of the nano-oscillators $\{NO_m\}$ to be monitored and the auxiliary nano-oscillator ($NO_{REF}$) by using a combiner leading to a two-tone combined signal $V_{mR}$ which comprises two tones with frequencies separated by a gap frequency ($f_{IF}$) such that:

$$f_{IF} = |f_m - f_{REF}|$$

- applying a non-linear amplification to the combined signal ($V_{mR}$) leading to an amplified multi-tone signal ($V_u$); and
- applying a low-pass or band-pass filtering around the frequency ($f_{IF}$) to the amplified signal ($V_u$) obtaining the output signal ($V_{out}$) of the one or more nano-oscillators.

2. The method according to claim 1, wherein the low frequency component ($f_{IF}$) fulfils that: $f_{IF} \ll f_m$ and $f_{IF} \ll F_{REF}$, when $f_m \approx f_{REF}$.

3. The method according to claim 1, wherein the frequency ($f_m$) is in a range of radio-frequency/microwave (RF/MW).

4. A device for monitoring the output signal (($V_{out}$) of one or more nano-oscillators *(NO)* driven by a magnetic field ($\vec{B}$), oscillating at a frequency $f_m$ when a bias current ($I_m$) applied to such nano-oscillators, is equal to $I_0$, and being at rest when the bias current ($I_m$) applied is supressed, the device comprising:

- at least one auxiliary nano-oscillator configured to be driven by the magnetic field ($\vec{B}$) and biased to a bias current ($I_{REF}$) leading to an oscillation at a specific frequency ($f_{REF}$) when driven by the magnetic field ($\vec{B}$);
- a combiner connected to the nano-oscillators *(NO)* to be monitored and the auxiliary nano-oscillator ($NO_{REF}$) and configured to combine an output signal of the nano-oscillators to be monitored and an output signal of the auxiliary nano-oscillator ($NO_{REF}$) into a combined signal ($V_{mR}$) which comprises a low frequency component ($f_{IF}$) such that:

$$f_{IF} = |f_m - f_{REF}|$$

- a non-linear amplifier connected to the combiner and configured to apply a non-linear amplification to the combined signal ($V_{mR}$), leading to an amplified signal ($V_u$);
- a band-pass filter connected to the non-linear amplifier and configured to apply a band-pass filtering around the low frequency component ($f_{IF}$) of the amplified signal ($V_u$) for obtaining the output signal ($V_{out}$) corresponding to the one or more nano-oscillators *(NO)*.

5. The device according to claim 4, wherein the nano-oscillators *(NO)* to be monitored and/or the auxiliary nano-oscillator ($NO_{REF}$) are selected from: a spin-Hall type nano-oscillators (SHNO) and spin-torque nano-oscillators (STNO).

6. A chip comprising multiple nano-oscillators *(NO)* arranged in a neuron-like array wherein the nano-oscillators *(NO)* are configured to act as neurons and a device for measuring the output signal ($V_{out}$) of the one or more nano-oscillators *(NO)* according to any of claims 4 to 5.

7. A magnetic field sensor comprising multiple nano-oscillators *(NO)* and a device for measuring the output signal ($V_{out}$) of the one or more nano-oscillators *(NO)* according to any of claims 4 to 5.

**FIGURE 1**

FIGURE 2

FIGURE 3

FIGURE 4

Europäisches Patentamt
European Patent Office
Office européen des brevets

**EUROPEAN SEARCH REPORT**

**Application Number**

EP 24 38 2803

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FIORELLI RAFAELLA ET AL: "CMOS Front End for Interfacing Spin-Hall Nano-Oscillators for Neuromorphic Computing in the GHz Range", ELECTRONICS, vol. 12, no. 1, 3 January 2023 (2023-01-03), page 230, XP093236511, Basel, Switzerland ISSN: 2079-9292, DOI: 10.3390/electronics12010230 * From section 2 entitled "NCS Scheme" to section 4 entitled "RF Front End".; page 2 - page 15 * ----- | 1-7 | INV. B82Y10/00 B82Y25/00 G06N3/065 H03B15/00 H10N52/00 |
| | | | TECHNICAL FIELDS SEARCHED (IPC) |
| | | | B82Y G01R H03D G06N H02N H03B H10N H03L |

The present search report has been drawn up for all claims

| Place of search | Date of completion of the search | Examiner |
|---|---|---|
| The Hague | 6 January 2025 | Wienema, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)